# FASCICULE DE BREVET EUROPEEN

(11) **EP 2 612 347 B1**
(45) Date de publication et mention de la délivrance du brevet: **21.01.2015**
(21) Numéro de dépôt: 11758495.3
(22) Date de dépôt: 31.08.2011
(51) Int. Cl.: H01L 21/18, H01L 21/02, H01L 21/98, H01L 23/535

(54) **TRAITEMENT AVANT COLLAGE D'UNE SURFACE MIXTE CU-OXYDE, PAR UN PLASMA CONTENANT DE L'AZOTE ET DE L'HYDROGÈNE**
BEHANDLUNG EINER MISCHKUPFEROXIDFLÄCHE VOR DEM BONDEN MIT EINEM STICKSTOFF- UND WASSERSTOFFHALTIGEN PLASMA
TREATMENT, BEFORE THE BONDING OF A MIXED COPPER OXIDE SURFACE, BY A PLASMA CONTAINING NITROGEN AND HYDROGEN

(30) Priorité: 31.08.2010 FR 1003496
(43) Date de publication de la demande: 10.07.2013
(73) Titulaire: Commissariat à l'Énergie Atomique et aux Énergies Alternatives, 75015 Paris (FR)
(72) Inventeur: VANDROUX, Laurent, F-38570 Le Cheylas (FR); DI CIOCCIO, Léa, F-38330 Saint Ismier (FR); GUEGUEN, Pierric, F-38130 Echirolles (FR)
(74) Mandataire: Talbot, Alexandre
(86) Numéro de dépôt international: PCT/FR2011/000484
(87) Numéro de publication internationale: WO 2012/028793

(56) Documents cités:
- US-A1- 2007 111 386
- US-A1- 2008 268 573
- US-B1- 6 472 755
- DI CIOCCIO ET AL: "Enabling 3D interconnects with metal direct bonding", 2009 IEEE INTERNATIONAL INTERCONNECT TECHNOLOGY CONFERENCE - IITC, 1 juin 2009 (2009-06-01), - 3 juin 2009 (2009-06-03), pages 152-154, XP002634230, ISBN: 978-1-4244-4492-2

## Description

### Domaine technique de l'invention

L'invention concerne un procédé de collage entre une première surface munie d'au moins une zone en cuivre entourée d'une zone en oxyde de silicium et une seconde surface.

### État de la technique

Le principe du collage par adhérence moléculaire ou collage direct est basé sur la mise en contact direct de deux surfaces, sans utilisation d'un matériau spécifique tel qu'une colle, une cire, un métal à basse température de fusion... Les surfaces destinées à être mises en contact peuvent être hydrophiles ou hydrophobes.

Une surface hydrophobe peut, par exemple, être une surface libre d'une plaquette (ou substrat) en silicium exempte d'oxyde de silicium, tandis qu'une surface hydrophile peut, par exemple, être une surface libre d'une plaquette en silicium comportant une couche mince d'oxyde de silicium.

Le procédé de collage par adhérence moléculaire nécessite, par ailleurs, que les surfaces à coller soient suffisamment lisses, exemptes de particules ou de contamination, qu'elles présentent une chimie de surface adaptée et qu'elles soient suffisamment rapprochées pour initier un contact. Dans ce cas, les forces attractives entre les deux surfaces sont assez élevées pour provoquer l'adhérence moléculaire.

Les collages sont, généralement, réalisés à température ambiante et à pression ambiante, après un nettoyage chimique des surfaces. Cependant, un traitement thermique ultérieur, par exemple à une température de l'ordre de 1000°C, est souvent réalisé pour renforcer les énergies de collage. Or, dans un très grand nombre d'applications, les étapes de traitement thermique à une telle température ne sont pas admises.

Des procédés de collage, ne nécessitant pas de traitements thermiques à si haute température, après la mise en contact des surfaces à coller, ont déjà été proposés. Ils comprennent en général une étape d'activation de surface préalable à la mise en contact et qui permet de limiter le traitement thermique de consolidation du collage entre 200 et 400°C.

Le procédé de collage peut, en particulier, être utilisé pour réaliser des interconnexions de substrats en trois dimensions, afin de miniaturiser les composants électroniques. Dans ce cas, les surfaces à coller comprennent en général des zones en cuivre destinées à être mises en contact les unes avec les autres pour assurer un contact électrique. Ces zones en cuivre sont, de plus, en général entourées par des zones en oxyde de silicium assurant l'isolation électrique entre plusieurs zones d'un même substrat et le collage entre les surfaces. De telles surfaces sont plus particulièrement appelées des surfaces hétérogènes (ou mixtes) Cu-Oxyde.

Lors de la mise en contact, un décalage, éventuellement minime, se produit inévitablement entre les zones en cuivre respectives des surfaces à coller. Avec ce décalage, trois types d'interfaces sont alors mis en jeu lors du collage :
- une interface entre le cuivre d'une surface et l'oxyde de silicium d'une autre surface (interface Cu-SiO₂)
- une interface entre le cuivre d'une surface et le cuivre de l'autre surface (interface Cu-Cu)
- et une interface entre l'oxyde de silicium d'une surface et l'oxyde de silicium de l'autre surface (interface SiO₂-SiO₂).

Pour obtenir un bon collage et de bonnes performances électriques, un traitement spécifique doit être réalisé pour chaque type d'interface:
- il est nécessaire de former une barrière au niveau de l'interface Cu/SiO₂, afin de bloquer la diffusion du cuivre depuis la zone en cuivre de la seconde surface vers la zone en oxyde de silicium de la première surface,
- au niveau de l'interface SiO₂-SiO₂, l'oxyde de silicium doit être activé pour permettre un bon collage,
- à l'interface Cu-Cu, il est nécessaire d'éliminer l'oxyde de cuivre qui se forme naturellement au niveau de la zone en cuivre de chaque surface à coller, afin d'améliorer les performances électriques du composant.

Or, les problèmes correspondant à ces différentes interfaces sont jusqu'à présent traités indépendamment les uns des autres.

De plus, compte tenu du caractère hétérogène d'une surface mixte Cu-Oxyde, il existe aussi des problèmes liés aux différents types d'interfaces rencontrés lorsqu'une telle surface mixte est directement collée à une autre surface, telle qu'une surface libre d'une couche continue en oxyde de silicium ou en métal ou en matériau semi-conducteur.

Le document US 2008/268 573 décrit un procédé de collage de substrats semi-conducteurs pour fabriquer des circuits en 3-dimensions, les substrats présentant des plots de cuivre, dans lequel les plots de cuivre sont traités par un plasma à base d'hydrogène ou d'ammoniac avant collage. Dans ce document les substrats ne sont toutefois en contact que par les plots de cuivre.

### Objet de l'invention

L'objet de l'invention est de proposer une solution unique, facile à mettre en oeuvre et économiquement viable pour assurer un collage de qualité entre une première surface munie d'au moins une zone en cuivre entourée d'une zone en oxyde de silicium et une seconde surface.

Selon l'invention, ce but est atteint par un procédé de collage entre une première surface munie d'au moins une zone en cuivre entourée d'une zone en oxyde de silicium et une seconde surface,
caractérisé en ce qu'avant la mise en contact entre les première et seconde surfaces, la première surface subit une opération de traitement par plasma, ledit plasma étant formé à partir d'une source gazeuse contenant un agent de nitruration de l'oxyde de silicium et un agent réducteur de l'oxyde de cuivre à base d'hydrogène.

Selon un premier développement de l'invention, l'agent de nitruration est du diazote et en ce que l'agent réducteur est choisi parmi l'ammoniac et le dihydrogène.

Selon un second développement de l'invention, l'agent de nitruration est du protoxyde d'azote et en ce que l'agent réducteur est du dihydrogène.

Selon un troisième développement de l'invention, l'agent de réducteur étant de l'ammoniac, il constitue l'agent de nitruration.

Selon un mode particulier de réalisation, la seconde surface étant munie d'au moins une zone en cuivre entourée d'une zone en oxyde de silicium, elle subit également, avant la mise en contact, une opération de traitement par plasma, ledit plasma étant formé à partir d'une source gazeuse contenant un agent de nitruration de l'oxyde de silicium et un agent réducteur de l'oxyde de cuivre à base d'hydrogène.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

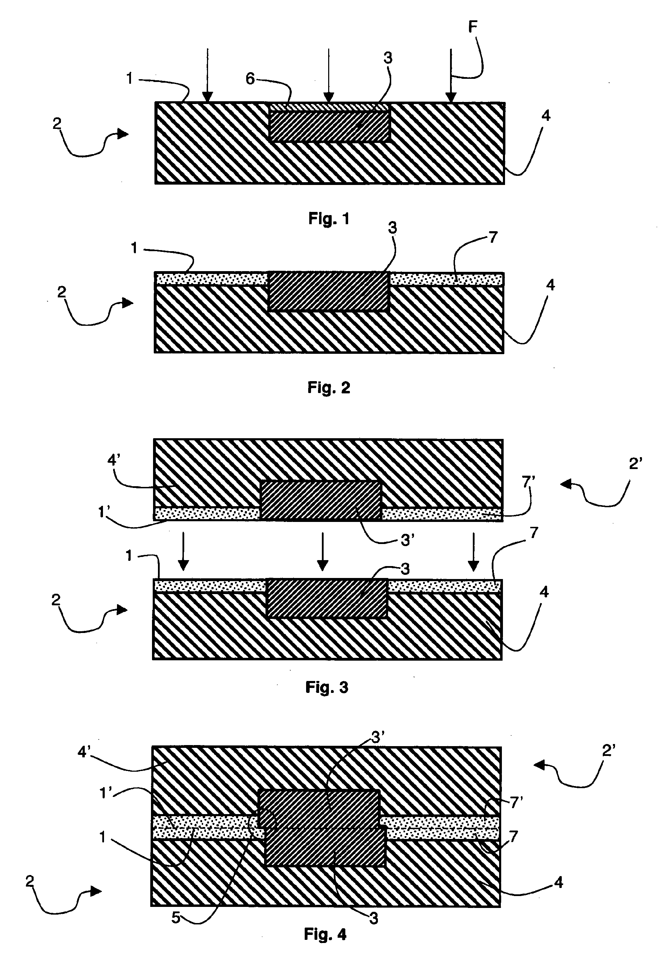

- les figures 1 à 4 illustrent schématiquement et en coupe différentes étapes d'un mode particulier de collage entre deux surfaces hétérogènes.

### Description de modes particuliers de réalisation

Un mode particulier de collage entre deux surfaces 1 et 1' hétérogènes Cu-oxyde appartenant respectivement à des substrats 2 et 2' est illustré par les figures 1 à 4.

Chaque substrat 2 (ou 2') est avantageusement un substrat en matériau semi-conducteur, tel qu'une plaquette en silicium (ou « wafer »). Comme illustré sur la figure 1, il comprend une surface 1 ou 1', avantageusement planes, dans laquelle est formée au moins une zone en cuivre 3 ou 3' entourée par une zone en silicium 4 ou 4'.

Les zones en cuivre 3 et 3' des substrats 2 et 2' sont, plus particulièrement, destinées à mettre mises en regard l'une de l'autre lors de la mise en contact, afin d'obtenir un contact électrique.

Les deux substrats présentent avantageusement au moins une surface plane de faible rugosité. Ces deux surfaces planes 1 et 1' sont destinées à être mises en regard puis collées. Cependant, il est également envisageable d'avoir deux surfaces 1 et 1' de formes complémentaires, c'est-à-dire pouvant s'emboiter sans se déformer ou trop se déformer lors de la mise en contact.

En particulier, dans le mode de réalisation représenté sur les figures 1 à 4, les zones en cuivre 3 et 3' présentent sensiblement la même forme (section rectangulaire) et les mêmes dimensions et elles sont destinées à être disposées en regard l'une de l'autre lors de la mise en contact entre les surfaces 1 et 1'. Ainsi, comme représenté sur la figure 4, la majeure partie de la zone en cuivre 3 est en contact avec la majeure partie de la zone en cuivre 3'. Cependant, lors de la mise en contact des deux surfaces, il n'est pas possible d'obtenir un alignement parfait des zones en cuivre 3 et 3' : un léger décalage 5 se forme nécessairement. Il est en général provoqué par les motifs de gravure utilisés pour former les zones 3 et 3' et qui ne permettent pas d'obtenir des zones en cuivre 3 et 3' parfaitement identiques et/ou parfaitement positionnées. Ce décalage 5 engendre, lors de la mise en contact, la création d'une interface de type Cu-Oxyde en plus des interfaces Cu-Cu et Oxyde-Oxyde qui permettent respectivement de former un contact électrique et d'assurer le collage entre les deux substrats 2 et 2'.

De plus, comme illustré sur la figure 1, avant la mise en contact entre les deux surfaces 1 et 1', chaque zone en cuivre comprend, de manière inhérente, un film mince superficiel 6 en oxyde de cuivre (CuO), qui peut être dommageable pour les performances électriques du composant que l'on souhaite obtenir après collage des deux surfaces.

Une opération de traitement par plasma est réalisée pour chaque surface 1 et 1' (flèches F sur la figure 1), avant la mise en contact des deux surfaces 1 et 1', afin d'obtenir, avantageusement lors d'une même opération de traitement, non seulement un bon collage entre les surfaces mais aussi de bonnes performances électriques. Ceci est obtenu en formant le plasma à partir d'une source gazeuse contenant un agent de nitruration de l'oxyde de silicium et un agent réducteur de l'oxyde de cuivre à base d'hydrogène.

La source gazeuse permettant de former le plasma peut en particulier comporter :
- du diazote N₂ comme agent de nitruration et de l'ammoniac NH₃ et/ou du dihydrogène H₂ comme agent réducteur de l'oxyde de cuivre, ou
- du protoxyde d'azote N₂O comme agent de nitruration et du dihydrogène H₂ comme agent réducteur de l'oxyde de cuivre, ou
- de l'ammoniac jouant à la fois le rôle d'agent de nitruration et celui d'agent réducteur de l'oxyde de cuivre.

Dans un mode particulier de réalisation, la source gazeuse est constituée par un gaz ou un mélange de gaz constituant l'agent de nitruration et l'agent réducteur à base d'hydrogène. Par contre, elle peut aussi, dans d'autres modes de réalisation, comporter un gaz neutre ou plusieurs gaz neutres, tels que l'hélium et/ou l'argon, servant de gaz de dilution.

Ainsi, le plasma obtenu à partir de cette source gazeuse comprend nécessairement de l'azote et de l'hydrogène.

Comme illustré sur la figure 2, l'azote présent dans le plasma permet en particulier de former un film mince superficiel 7 au niveau de la zone en oxyde de silicium, en oxynitrure de silicium (SiₓO_{y}N_{z} ou oxyde de silicium nitruré). Ce film mince superficiel 7 forme, alors, une barrière à la diffusion du cuivre dans les zones en oxyde de silicium tant verticalement qu'horizontalement sur la figure 4, tout en laissant les surfaces 1 et 1' aptes au collage. De plus, l'azote présent dans le plasma ne détériore pas les performances électriques des zones en cuivre 3 et 3'.

L'hydrogène présent dans le plasma permet par ailleurs d'éliminer le film mince superficiel 6 ou 6' en oxyde de cuivre présent dans la zone en cuivre 3 ou 3', améliorant les performances électriques de l'assemblage une fois le collage réalisé. De plus, l'hydrogène présent dans le plasma est inactif pour l'oxyde de silicium.

Les figures 3 et 4 illustrent la mise en contact des surfaces 1 et 1' permettant d'obtenir un contact électrique entre les zones en cuivre 3 et 3'. Cette mise en contact permet ainsi l'obtention d'une interface hétérogène entre les deux surfaces 1 et 1' (représentée par les traits en pointillés sur la figure 4). Cette interface hétérogène formée d'au moins trois parties distinctes :
- une partie formée d'une interface Oxyde-Oxyde obtenue par la mise en contact entre les films minces superficiels 7 et 7' en oxyde de silicium nitruré,
- une partie formée d'une interface Cuivre-Cuivre obtenue par la mise en contact des zones en cuivre 3 et 3'
- et une partie formée par une interface Cuivre-Oxyde obtenue par la mise en contact d'une zone en cuivre 3 ou 3' d'une surface 1 ou 1' avec le film mince superficiel 7' ou 7 en oxyde de silicium nitruré de la surface 1' ou 1.

Si les surfaces 1 et 1' subissent une opération préalable d'activation de surface par polissage mécano-chimique (CMP), le traitement de surface par plasma ne dégrade pas cette opération d'activation de surface. Si les surfaces ne sont pas activées préalablement par polissage mécano-chimique, l'azote présent dans le plasma permet d'activer la surface en oxyde de silicium.

Le collage de deux surfaces complémentaires présentant une faible rugosité, par exemple deux surfaces planes, permet d'avoir un collage direct efficace. L'utilisation de surfaces complémentaires permet de limiter la détérioration du film mince superficiel 7 des surfaces en oxyde de silicium de la surface 1 par des zones en saillies de la surface 1' ce qui permet d'augmenter la surface de contact active pour le collage direct. La mise en contact est avantageusement dépourvue de déformation visant à enfoncer un motif en saillie d'un des substrats dans l'autre substrat pour limiter la pression nécessaire à la mise en contact et réaliser le collage direct.

Une étape ultérieure de recuit peut aussi être réalisée après la mise en contact des deux surfaces 1 et 1', afin d'obtenir une recristallisation à l'interface Cuivre-Cuivre et stabiliser le cuivre. Une telle étape est avantageusement réalisée à une température comprise entre la température ambiante et 450°C.

À titre d'exemple, l'opération de traitement par plasma peut être réalisée dans un réacteur mono-plaque (plaque 200mm) utilisé pour réaliser les dépôts chimiques en phase vapeur assisté par plasma (PECVD) à plaques parallèles avec une décharge plasma. Les conditions dans lesquelles est réalisée l'opération de traitement par plasma sont, avantageusement les suivantes :
- température dans le réacteur comprise entre 150°C et 450°C,
- pression dans le réacteur comprise entre 133,3 Pa (1Torr) et 2000 Pa (15 Torrs),
- puissance RF permettant la création du plasma comprise entre 50 et 1000W,
- durée de l'opération entre 10 et 300 secondes,
- source gazeuse avec un débit variable et variant de 0 à 5000 sccm pour les gaz NH₃, H₂, N₂, N₂O et He, afin d'obtenir un plasma contenant N et H.

L'opération de traitement de surface par plasma peut aussi être réalisée dans une chambre de gravure ionique réactive (RIE). Dans ce cas, les conditions sont identiques à celles mentionnées ci-dessus, à l'exception de la température qui est, en général, comprise entre la température ambiante et 150°C et la pression qui est, de préférence, inférieure à 133,3 Pa (1Torr).

De la même manière, elle peut aussi être réalisée dans un réacteur en plasma atmosphérique. Dans ce cas, l'opération de traitement de surface par plasma est réalisée à pression atmosphérique, avec une température pouvant être comprise entre la température ambiante et 450°C ; la puissance, la durée et les débits de gaz étant similaires à ceux exposés ci-dessus.

Enfin, l'invention n'est pas limitée à un procédé de collage entre deux surfaces mixtes Cu-Oxyde. En effet, l'opération de traitement de surface par plasma telle que celle décrite ci-dessus peut aussi être appliquée à une seule surface mixte Cu-Oxyde, dans le cadre d'un collage direct entre ladite surface mixte Cu-Oxyde avec une autre surface, telle qu'une surface libre d'une couche continue en oxyde (par exemple oxyde de silicium), métallique (par exemple en cuivre) ou en matériau semi-conducteur (par exemple en silicium). Le collage a lieu dans la zone en cuivre et dans la zone en oxyde de silicium. Dans ce cas, avec la mise en contact des deux surfaces, la surface mixte Cu-Oxyde subit l'opération de traitement de surface par plasma telle que décrite plus haut, tandis que l'autre surface peut subir une opération de préparation selon des techniques classiques dans le domaine du collage direct (planarisation, activation,...).

## Revendications

1. Procédé de collage entre une première surface (1) munie d'au moins une zone en cuivre (3) entourée d'une zone en oxyde de silicium (4) et une seconde surface (1'),
**caractérisé en ce qu'**il comporte les étapes suivantes :
- prévoir les première et seconde surfaces (1, 1') présentant des formes complémentaires avant leur mise en contact,
- soumettre la première surface (1) à une opération de traitement par plasma, ledit plasma étant formé à partir d'une source gazeuse contenant un agent de nitruration de l'oxyde de silicium et un agent réducteur de l'oxyde de cuivre à base d'hydrogène,
- mettre en contact les première et secondes surfaces (1, 1') de manière à avoir le collage direct de la première surface avec la deuxième surface à l'interface entre la zone en cuivre et le deuxième substrat et à l'interface entre la zone en oxyde de silicium et le deuxième substrat.

2. Procédé selon la revendication 1, **caractérisé en ce que** l'agent de nitruration est du diazote et **en ce que** l'agent réducteur est choisi parmi l'ammoniac, le dihydrogène et un mélange des deux.

3. Procédé selon la revendication 1, **caractérisé en ce que** l'agent de nitruration est du protoxyde d'azote et **en ce que** l'agent réducteur est du dihydrogène.

4. Procédé selon la revendication 1, **caractérisé en ce que** l'agent de réducteur étant de l'ammoniac, il constitue l'agent de nitruration.

5. Procédé selon l'une quelconque des revendications 1 à 4, **caractérisé en ce que** la source gazeuse comporte au moins un gaz neutre.

6. Procédé selon la revendication 5, **caractérisé en ce que** le gaz neutre est choisi parmi l'hélium et l'argon.

7. Procédé selon l'une quelconque des revendications 1 à 6, **caractérisé en ce que** l'opération de traitement plasma est précédée pour la première surface (1) d'une opération de polissage mécano-chimique.

8. Procédé selon l'une quelconque des revendications 1 à 7, **caractérisé en ce que** la mise en contact entre les première et seconde surfaces (1, 1') est suivie d'une opération de recuit de recristallisation du cuivre.

9. Procédé selon l'une quelconque des revendications 1 à 8, **caractérisé en ce que** la seconde surface (1') étant munie d'au moins une zone en cuivre (3') entourée d'une zone en oxyde de silicium (4'), elle subit également, avant la mise en contact, une opération de traitement par plasma, ledit plasma étant formé à partir d'une source gazeuse contenant un agent de nitruration de l'oxyde de silicium et un agent réducteur de l'oxyde de cuivre à base d'hydrogène.

10. Procédé selon la revendication 9, **caractérisé en ce que** la mise en contact entre les première et seconde surfaces (1, 1') forme une interface hétérogène comprenant une partie cuivre-cuivre, une partie oxyde de silicium nitruré-oxyde de silicium nitruré et une interface cuivre-oxyde de silicium nitruré.

11. Procédé selon l'une quelconque des revendications 1 à 10, **caractérisé en ce que** les première et seconde surfaces (1, 1') sont planes.

## Patentansprüche

1. Verfahren zum Bonden zwischen einer ersten Fläche (1), die mit wenigstens einem von einem Siliziumoxidbereich (4) umgebenden Kupferbereich (3) versehen ist, und einer zweiten Fläche (1'),
**dadurch gekennzeichnet, dass** es die folgenden Schritte umfasst:
- die erste und die zweite Fläche (1, 1'), die ergänzende Formen aufweisen, vor ihrem Inkontaktbringen bereitstellen,
- die erste Fläche (1) einem Plasmabehandlungsvorgang unterziehen, wobei das Plasma mittels einer Gasquelle, die ein Mittel zur Nitrierung des Siliziumoxide und ein Kupferoxidreduktionsmittel auf Wasserstoffbasis enthält, gebildet wird,
- die erste und die zweite Fläche (1, 1') in Kontakt bringen, um das direkte Bonden der ersten Fläche mit der zweiten Fläche an der Schnittstelle zwischen dem Kupferbereich und dem zweiten Substrat sowie an der Schnittstelle zwischen dem Siliziumoxidbereich und dem zweiten Substrat zu erhalten.

2. Verfahren nach Anspruch 1, **dadurch gekennzeichnet, dass** das Nitrierungsmittel Distickstoff ist und dass das Reduktionsmittel aus Ammoniak, Diwasserstoff und einer Mischung aus beiden ausgewählt ist.

3. Verfahren nach Anspruch 1, **dadurch gekennzeichnet, dass** das Nitrierungsmittel Distickstoffmonoxid ist und dass das Reduktionsmittel Diwasserstoff ist.

4. Verfahren nach Anspruch 1, **dadurch gekennzeichnet, dass** wenn das Reduktionsmittel Ammoniak ist, es das Nitrierungsmittel bildet.

5. Verfahren nach einem der Ansprüche 1 bis 4, **dadurch gekennzeichnet, dass** die Gasquelle wenigstens ein neutrales Gas umfasst.

6. Verfahren nach Anspruch 5, **dadurch gekennzeichnet, dass** das neutrale Gas aus Helium und Argon ausgewählt ist.

7. Verfahren nach einem der Ansprüche 1 bis 6, **dadurch gekennzeichnet, dass** bei der ersten Fläche (1) dem Plasmabehandlungsvorgang ein mechanisch-chemischer Poliervorgang vorausgeht.

8. Verfahren nach einem der Ansprüche 1 bis 7, **dadurch gekennzeichnet, dass** sich an das Inkontaktbringen zwischen der ersten und der zweiten Fläche (1, 1') ein Glühvorgang zur Rekristallisation des Kupfers anschließt.

9. Verfahren nach einem der Ansprüche 1 bis 8, **dadurch gekennzeichnet, dass** wenn die zweite Fläche (1') mit wenigstens einem von einem Siliziumoxidbereich (4') umgebenen Kupferbereich (3') versehen ist, sie ebenfalls vor dem Inkontaktbringen einem Plasmabehandlungsvorgang unterzogen wird, wobei das Plasma mittels einer Gasquelle, die ein Mittel zur Nitrierung des Siliziumoxids und ein Kupferoxidreduktionsmittel auf Wasserstoffbasis enthält, gebildet wird.

10. Verfahren nach Anspruch 9, **dadurch gekennzeichnet, dass** das Inkontaktbringen zwischen der ersten und der zweiten Fläche (1,1') eine heterogene Schnittstelle, umfassend einen Kupfer-Kupfer-Teil, einen nitriertes Siliziumoxidnitriertes Siliziumoxid-Teil und eine Kupfer-nitriertes Siliziumoxid-Schnittstelle bildet.

11. Verfahren nach einem der Ansprüche 1, bis 10, **dadurch gekennzeichnet, dass** die erste und die zweite Fläche (1, 1') eben sind.

## Claims

1. A method for bonding a first surface (1) provided with at least one copper area (3) surrounded by a silicon oxide area (4) to a second surface (1'),
**characterized in that** it comprises the steps of:
- providing the first and second surfaces (1, 1') having complementary shapes before they are placed into contact,
- submitting the first surface (1) to a plasma treatment operation, said plasma being formed from a gas source containing a silicon oxide nitriding agent and a copper oxide reducing agent containing hydrogen,
- placing into contact the first and second surfaces (1, 1') to have the direct bonding of the first surface to the second surface at the interface between the copper area and the second substrate and at the interface between the silicon oxide area and the second substrate.

2. The method of claim 1, **characterized in that** nitriding agent is dinitrogen and **in that** the reducing agent is selected from among ammonia, dihydrogen, and a mixture thereof.

3. The method of claim 1, **characterized in that** the nitriding agent is nitrous oxide and **in that** the reducing agent is dihydrogen.

4. The method of claim 1, **characterized in that** the reducing agent being ammonia, it forms the nitriding agent.

5. The method of any of claims 1 to 4, **characterized in that** the gas source comprises at least one neutral gas.

6. The method of claim 5, **characterized in that** the neutral gas is selected from among helium and argon.

7. The method of any of claims 1 to 6, **characterized in that** the plasma treatment operation is preceded for the first surface (1) by a chemical-mechanical polishing operation.

8. The method of any of claims 1 to 7, **characterized in that** the placing into contact of the first and second surfaces (1, 1') is followed by an operation of copper recrystallization annealing.

9. The method of any of claims 1 to 8, **characterized in that** the second surface (1') being provided with at least one copper area (3') surrounded by a silicon oxide area (4'), it is also submitted, before the placing into contact, to a plasma treatment operation, said plasma being formed from a gas source containing a silicon oxide nitriding agent and a copper oxide reducing agent containing hydrogen.

10. The method of claim 9, **characterized in that** the placing into contact of the first and second surfaces (1, 1') forms a heterogeneous interface comprising a copper - copper portion, a nitrided silicon oxide - nitrided silicon oxide portion, and a copper - nitrided silicon oxide interface.

11. The method of any of claims 1 to 10, **characterized in that** the first and second surfaces (1, 1') are planar.
